## Europäisches Patentamt
## European Patent Office
## Office européen des brevets

(19)

(11) Veröffentlichungsnummer: **0 170 315**
**A2**

(12) # EUROPÄISCHE PATENTANMELDUNG

(21) Anmeldenummer: 85201073.5

(22) Anmeldetag: 03.07.85

(51) Int. Cl.⁴: **H 05 K 13/04**

(30) Priorität: 04.07.84 DE 3424546

(43) Veröffentlichungstag der Anmeldung:
05.02.86 Patentblatt 86/6

(84) Benannte Vertragsstaaten:
DE FR GB

(71) Anmelder: Philips Patentverwaltung GmbH
Billstrasse 80
D-2000 Hamburg 28(DE)

(84) Benannte Vertragsstaaten:
DE

(71) Anmelder: N.V. Philips' Gloeilampenfabrieken
Groenewoudseweg 1
NL-5621 BA Eindhoven(NL)

(84) Benannte Vertragsstaaten:
FR GB

(72) Erfinder: Berkard, Wilfried
Gageldonk 5
D-4150 Krefeld(DE)

(72) Erfinder: Prange, Wolfgang
Pempelfurthstrasse 54
D-4150 Krefeld(DE)

(74) Vertreter: Kupfermann, Fritz-Joachim et al,
Philips Patentverwaltung GmbH Billstrasse 80 Postfach
10 51 49
D-2000 Hamburg 28(DE)

(54) Maschine zum automatischen Bestücken von Schaltungsplatten.

(57) Machine zum automatischen Bestücken von Schaltungsplatten (3) mit axial bedrahteten Bauteilen (11), deren Anschlußdrähte (13) beim Bestücken abgebogen und mittels eines Treibers (9) in Löcher (23) der Schaltungsplatte eingetrieben werden mittels eines Unterwerkzeuges zum Bearbeiten der durchgesteckten Anschlußdrähte. Das Unterwerkzeug und der Treiber sind dabei mit Polen einer Prüfspannungsmeßvorrichtung derart verbunden, daß die Machine die Anschlußdrähte nach ihrem Einstecken prüfen kann, ob der jeweils vom Treiber einzutreibende Anschlußdraht auch tatsächlich korrekt eingetrieben ist. Der Treiber ist in einer Schiene geführt, in deren Längsrichtung auf das Antriebsende des Treibers ein in seinem Bewegungsweg einstellbarer Stößel einwirkt. Der Treiber ist in einer Schiene geführt. Auf das Antriebsende (31) des Treibers (9) wirkt ein Stößel (27). Zwischen dem Stößel (27) und dem Treiber (9) ist ein federndes Längenausgleichsteil (23) in Form einer axial zusammendrückbaren Feder oder eines Gummiklotzes vorgesehen. Die Steifigkeit des Längenausgleichsteiles ist kleiner als die beim Eintreiben aufzuwendende Eintreibkraft.

Maschine zum automatischen Bestücken von Schaltungsplatten

Die Erfindung bezieht sich auf eine Maschine zum automatischen Bestücken von Schaltungsplatten mit axial bedrahteten Bauteilen, deren Anschlußdrähte beim Bestücken abgebogen und mittels eines Treibers in Löcher der Schaltungsplatte getrieben werden, mit einem Unterwerkzeug zum Bearbeiten der durchgesteckten Anschlußdrähte, wobei das Unterwerkzeug und der Treiber mit den Polen einer Prüfspannung derart verbunden sind, daß die Maschine nach dem Einstecken elektrisch prüfen kann, ob der jeweils vom Treiber einzutreibende Anschlußdraht auch tatsächlich korrekt eingetrieben ist, und wobei der Treiber in einer Schiene geführt ist, in deren Längsrichtung auf das Antriebsende des Treibers ein in seinem Bewegungsweg einstellbarer Stößel einwirkt.

Maschinen dieser Art sind aus der DE-GmS 84 04 796 bekannt. Zum automatischen Bestücken von Schaltungsplatten mit axial bedrahteten Bauteilen werden die Bauteile mit axial ausgerichteten Anschlußdrähten an Klebebändern zugeführt, auf die die Drahtenden der Bauelemente aufgeklebt sind. Innerhalb der Bestückungsmaschine werden die Anschlußdrähte von den Bändern abgetrennt und an beiden Enden des Bauteiles rechtwinklig abgebogen. Die freien Enden der Anschlußdrähte stehen dann parallel zueinander, so daß das Bauteil mit seinen Anschlußdrähten in etwa ein U bildet, in dessen Basisschenkel sich das Bauteil selbst befindet. Dieser Formungszustand wird von einem am Oberwerkzeug vorgesehnen Außenformer herbeigeführt, der zwei
Schienen aufweist, in denen sogenannte Treiber geführt
sind. Der Außenformer wird so gesteuert, daß die Anschlußdrähte über zum Bestücken vorgesehene Löcher einer Schaltungsplatte gelangen. Im Außenformer fahren dann Stößel
auf die Stößel nieder, welche die in den Schienen geführten Treiber im Bereich der Drahtbögen gegen die noch in
Achsrichtung verlaufenden Anschlußdrahtteile stoßen. Die
Treiber treiben dabei die Anschlußdrähte und mithin das
gesamte Bauteil so weit gegen die Schaltungsplatte, daß
das Bauteil in etwa auf der Schaltungsplatte aufliegt und
die freien Enden der Anschlußdrähte durch Löcher in der
Schaltungsplatte durchgreifen. Vom Unterwerkzeug her
werden dann mit Hilfe von Messerschiebern die Überlängen
der freien Anschlußdrahtenden abgeschnitten und die neu
gebildeten Anschlußdrahtenden etwas verbogen, damit die
Anschlußdrähte nicht mehr aus der Schaltungsplatte zurück
und herausrutschen können.

Bei diesem automatischen Bestücken mit hoher Bestückungsfolge und damit hohen Bestückungszahlen pro Zeiteinheit
ist es wichtig, eine ständige Kontrolle über den Bestückungsvorgang auszuüben. Nur so lassen sich größere Bestückungsfehler vermeiden.

Bei den Maschinen zum automatischen Bestücken ist zur
Kontrolle der Bestückung vorgesehen, daß nach jedem einzelnen Bestückungsvorgang der Stromdurchgang zwischen dem
Oberwerkzeug und dem Unterwerkzeug geprüft wird. Das positive Meßergebnis ist dann ein Indiz dafür, daß die Anschlußdrähte des Bauelementes auch tatsächlich durch die
Löcher in der Schaltungsplatte hindurchgesteckt sind. Die Messung erfolgt vorzugsweise in der Art, daß das Massepotential des Oberwerkzeuges über den jeweiligen Treiber
und den Anschlußdraht des Bauteiles zum linken und rechten
Teil des Unterwerkzeuges durchverbunden wird.

Es hat sich nun gezeigt, daß die maschinelle Ausrüstung
über den Treiber keine zuverlässige Kontaktierung gewährleistet. Die Bauteile haben nicht immer den gleichen
Durchmesser, und die Anschlußdrähte haben nicht immer die
gleiche Biegesteifigkeit. Immer dann, wenn ein Treiber
nicht die erforderliche Kontaktierung herbeiführt, obwohl
das Bauteil richtig eingesetzt ist, signalisiert die angeschlossene Meßvorrichtung einen Bestückungsfehler, und die
Maschine wird stillgesetzt. Das Signalisieren eines
Fehlers, obwohl gar kein Fehler vorliegt, stört den
Betriebsablauf ganz erheblich. Wenn solche Fehlsignale zu
häufig auftreten, dann helfen sich die Bedienungspersonen
in der Weise, daß sie eine Masseüberbrückung außerhalb der
Schaltungsplatte vornehmen. Damit sind fehlerhafte Signale
bei korrekter Bestückung ausgeschaltet. Nun können aber
wirkliche Fehlbestückungen, bei denen beispielsweise nur
ein Anschlußdraht durch die Schaltungsplatte hindurchgesteckt ist und der andere irgendwie oberhalb der Schaltungsplatte verbogen wurde, nicht mehr festgestellt
werden.

Der maschinelle Aufbau des Oberwerkzeuges ist derart getroffen, daß der Treiber für jeden Anschlußdraht vom
Stößel bis auf eine bestimmte Höhe gegenüber der Schaltungsplatte geschlagen wird. Die Höhe wird nach einer vorprogrammierten Höhe für jeden Bauteiltyp eingestellt, weil
verschiedene Bauteile auch verschiedene Bauteiltypen auch verschiedene Durchmesser haben. Der Stößel gibt also die genaue Tiefstellung des Treibers an, und allein schon eine leichte veränderte Krümmung des Anschlußdrahte kann dazu führen, daß der Treiber den Anschlußdraht nicht berührt und dementsprechend nicht den erforderlichen Kontakt herbeiführt.

Es ist Aufgabe der Erfindung, eine Maschine der eingangs erwähnten Art zu schaffen, mit der gewährleistet ist, daß der Treiber immer sicher an dem Anschlußdraht anliegt und damit zuverlässig Kontakt gibt bei korrekt durch das Loch der Schaltungsplatte hindurchgestecktem Anschlußdraht.

Die gestellte Aufgabe ist erfindungsgemäß dadurch gelöst, daß zwischen dem Stößel und dem Treiber ein federndes Längenausgleichsteil vorgesehen ist, dessen Steifigkeit kleiner ist als die beim Eintreiben aufzuwendende Eintreibkraft.

Durch die Einfügung eines federnden Längenausgleichsteiles ist sichergestellt, daß der Treiber auch bei Abmessungs- und Biegungstoleranzen am Bauteil immer sicher gegen den Anschlußdraht drückt und damit den erforderlichen Massekontakt herstellt. Fehlerhafte Signale bei korrekter Bestückung sind damit ausgeschlossen.

Das federnde Längenausgleichsteil kann auf verschiedene Weise gebildet sein. Nach weiteren Ausgestaltungen der Erfindung besteht es entweder aus einer axial zusammendrückbaren Feder oder aus einem Gummiklotz.

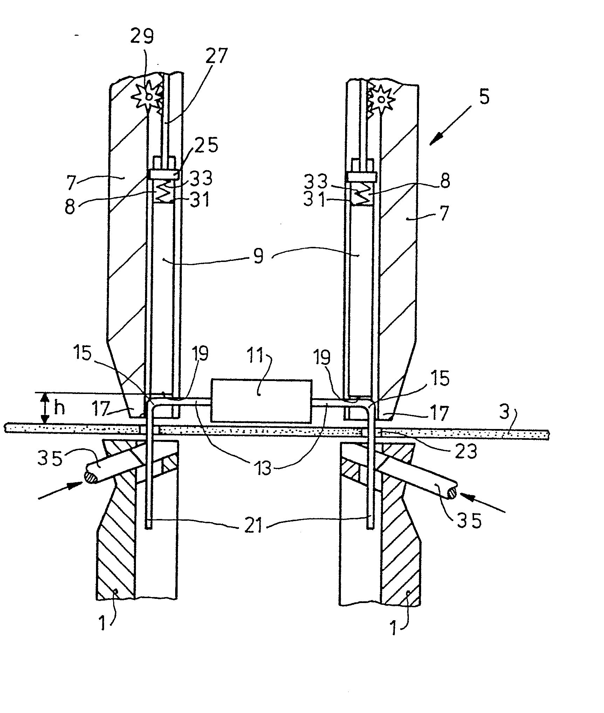

Die Erfindung wird anhand des in der Zeichnung dargestellten Ausführungsbeispieles näher erläutert.

Die Zeichnung zeigt das Unterwerkzeug 1 einer Maschine zum automatischen Bestücken von Schaltungsplatten, auf dem eine Schaltungsplatte 3 aufliegt. Oberhalb der Schaltungsplatte befindet sich ein Oberwerkzeug 5, zu dem ein Außenformer 7 und in ihm mittels Schienen 8 geführte Treiber 9 gehören.

Die Schaltungsplatte 3 soll mit einem elektrischen Bauteil 11, beispielsweis einem Kondensator oder einem Widerstand, bestückt werden. Das Bauteil 11 ist axial bedrahtet mit Anschlußdrähten 13, die bei dem Zuführen in die Maschine zunächst axial gestreckt sind.

Im Oberwerkzeug werden die Anschlußdrähte 13 nach dem Erfassen in der Maschine rechtwinklig abgebogen, wobei die Anschlußdrahtbögen 15 zwischen Vorsprünge 17 des Außenformers und die Treibenden 19 der Treiber 9 gelangen.

Mit Hilfe der Treiber 9 werden die freien Enden 21 der Anschlußdrähte dann in Löcher 23 der Schaltungsplatte eingetrieben. Der Eintreibeweg der Treiber 9 ist im Programmspeicher der Maschine festgelegt. Das Niederdrücken der Treiber 9 erfolgt mit Hilfe von Anschlägen 25, die an Stößeln 27 angeordnet sind. Die Stößel 27 können mit Hilfe einer beliebigen Antriebsvorrichtung 29, beispielsweise Zahnrad und Zahnstange, bewegt werden. Zwischen den Anschlägen 25 und Antriebsenden 31 der Treiber befinden sich etwa 0,5 mm lange Längenausgleichsteile 33 in Form von Gummiklötzen oder axial zusammendrückbaren Federn, deren Steifigkeit kleiner als die beim Eintreiben aufzuwendende Eintreibkraft ist. Während des normalen Eintreibvorganges wirkt damit das Gebilde aus Stößeln 27, Längenausgleichsteilen 33 und Treibern 9 wie eine steife Einheit. Die Stößel 27 werden so gesteuert, daß die Treibenden 19 für einen bestimmten Bauteiltyp bis auf eine Höhe h an die Schaltungsplatte 3 heranfahren. Dies ist die Höhe, bei der das Bauteil 11 etwa an der Schaltungsplatte 3 anliegt. Wenn die Treiber 9 mit ihren Treibenden 19 bis auf die Höhe h niedergefahren sind, dann sind die Anschlußdrähte 21 durch die Löcher 23 in der Schaltungsplatte 3 hindurchgefahren. Messerschieber 35 schneiden daraufhin die Überlängen der Anschlußdrähte 13 ab und biegen die verbleibenden Enden ein wenig um, so daß das Bauteil nicht mehr abfallen kann.

Nach diesem Abschluß des Bauteilsetzens tasten die Treiber 9 ab, ob das Bauteil richtig gesetzt ist, d. h. ob beide Anschlußdrähte durch die Löcher 23 der Schaltungsplatte 3 auch tatsächlich hindurchgefürt sind. Das Oberwerkzeug 5 und die Treiber 9 liegen auf Massepotential. Die linken und rechten Hälften des Unterwerkzeuges 1 liegen auf unterschiedlichen Prüfpotentialen. Durch das Abschneiden und Umbiegen der Anschlußdrähte 13 ist es möglich, daß die Bögen 15 in den Anschlußdrähten sich so verformt haben, daß ihre Oberkante einen kleineren Abstand als den Abstand h von der Oberseite der Schaltungsplatte 3 erhalten haben. Diese Höhendifferenz wird ausgeglichen von den Längenausgleichsteilen 33, die die Treiber 9 über den Abstand h hinweg weiter auf die Schaltungsplatte 3 drücken. Damit ist ein zuverlässiger Kontakt im Augenblick der elektrischen Durchgangsprüfung sichergestellt. Es gibt also keine Fehlmessungen der Maschine, die bei ordentlich bestücktem Bauteil zu Maschinenstillstand führen könnten.

0170315

<u>PATENTANSPRÜCHE</u>

1. Maschine zum automatischen Bestücken von Schaltungsplatten mit axial bedrahteten Bauteilen, deren Anschlußdrähte beim Bestücken abgebogen und mittels eines Treibers in Löcher der Schaltungsplatte getrieben werden, mit einem Unterwerkzeug zum Bearbeiten der durchgesteckten Anschlußdrähte, wobei das Unterwerkzeug und der Treiber mit den Polen einer Prüfspannung derart verbunden sind, daß die Maschine nach dem Einstecken elektrisch prüfen kann, ob der jeweils vom Treiber einzutreibende Anschlußdraht auch tatsächlich korrekt eingetrieben ist, und wobei der Treiber in einer Schiene geführt ist, in deren Längsrichtung auf das Antriebsende des Treibers ein in seinem Bewegungsweg einstellbarer Stößel einwirkt, dadurch gekennzeichnet, daß zwischen dem Stößel (27) und dem Treiber (9) ein federndes Längenausgleichsteil (33) vorgesehen ist, dessen Steifigkeit kleiner ist als die beim Eintreiben aufzuwendende Eintreibkraft.

2. Maschine nach Anspruch 1, dadurch gekennzeichnet, daß das Längenausgleichsteil eine axial zusammendrückbare Feder ist.

3. Maschine nach Anspruch 1, dadurch gekennzeichnet, daß das Längenausgleichsteil (33) ein Gummiklotz ist.